(19) Europäisches Patentamt
European Patent Office
Office européen des brevets

(11) **EP 1 935 095 B1**

(12) **EUROPEAN PATENT SPECIFICATION**

(45) Date of publication and mention
of the grant of the patent:
**04.11.2009 Bulletin 2009/45**

(51) Int Cl.:
***H03K 5/1254*** *(2006.01)*

(21) Application number: **07766264.1**

(86) International application number:
**PCT/GB2007/002694**

(22) Date of filing: **17.07.2007**

(87) International publication number:
**WO 2008/009918 (24.01.2008 Gazette 2008/04)**

(54) **A DEBOUNCING CIRCUIT**

ENTPRELLUNGSSCHALTUNG

CIRCUIT ANTI-REBOND

(84) Designated Contracting States:
**AT BE BG CH CY CZ DE DK EE ES FI FR GB GR
HU IE IS IT LI LT LU LV MC MT NL PL PT RO SE
SI SK TR**

(30) Priority: **18.07.2006 GB 0614259**

(43) Date of publication of application:
**25.06.2008 Bulletin 2008/26**

(73) Proprietor: **GS IP Limited Liability Company
Wilmington, Delaware 19808 (US)**

(72) Inventor: **MACAULAY, Rob
Cambridge CB1 2LD (GB)**

(74) Representative: **Slingsby, Philip Roy et al
Page White & Farrer
Bedford House
John Street
GB-London WC1N 2BF (GB)**

(56) References cited:
**EP-A- 1 643 349          US-A1- 2005 285 449
US-A1- 2006 076 984**

**Description**

The present invention relates to a debouncing circuit for removing high frequency oscillations in a switch output that may arise when contact is made and broken between two contact elements of the switch.

Switches or keys are widely used as user input devices. Many switches are mechanical devices. In the simplest case, a switch consists of two pieces of metal called contacts that touch to make a circuit and separate to break a circuit. The actuator that applies the operating force to the contacts may be any type of mechanical linkage, e.g. a toggle, rocker or push button, or may arise automatically, as in a relay.

Simple metal contact switches include spring-loaded keys that have plungers with a strip of metal on their underside for contacting two parts of a circuit. In a variation, a small piece of foam may be placed between the bottom of the plunger and the metal strip. Such switches have the advantages of providing a good tactile response and being inexpensive to produce. However, the contacts tend to wear out or corrode quite quickly. Other switches include rubber dome switches and membrane switches.

Rubber dome switches use small, flexible rubber domes that have a hard carbon centre. When a key is pressed, a plunger on the bottom of the key pushes down against the dome and causes the carbon centre to press against a surface beneath the key. While the key is pressed, the carbon centre completes the surface. When the key is released, the dome springs back to its original position and the circuit is broken. Rubber dome switches also provide a reasonable tactile response and are inexpensive.

Membrane switches are typically used for keypads or keyboards. Rather than having a switch for each key, they use a continuous membrane having a pattern printed on it that completes a circuit when a key is pressed. Some membrane keyboards use a flat surface printed with representations of each key rather than using separate key heads for individual keys. Membrane keyboards do not have a good tactile response but they are generally inexpensive.

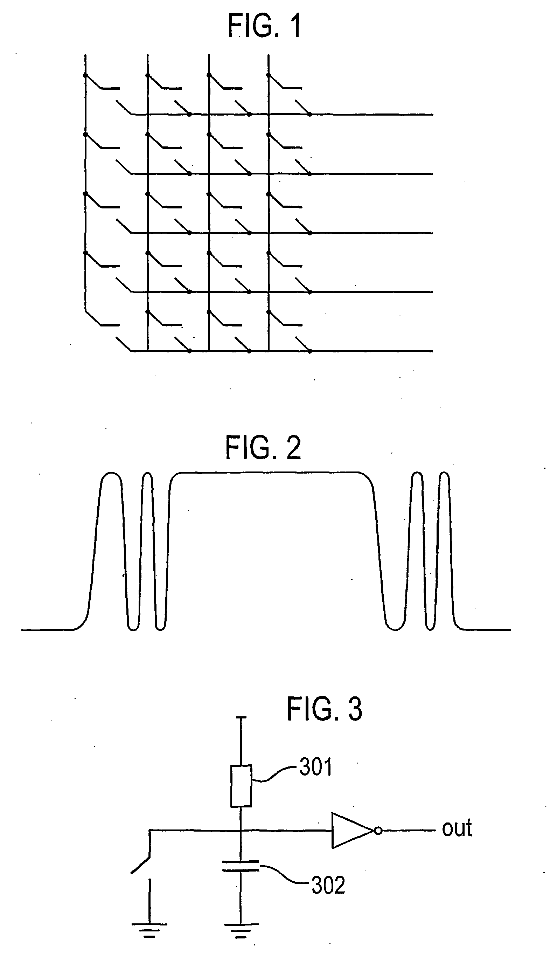

Switches are often grouped together to form keypads or keyboards having multiple switches. Rather than having each key or switch connected to an individual wire, keyboards are typically arranged so that the keys or switches are connected in rows and columns to form a matrix. In order to detect key presses, the keyboard typically 'scans' the matrix by activating each column in turn and then detecting which rows are activated. A column is activated by passing an electric current through it. A key press is detected when an electric current is output by a row. When a column is activated and an electric current is output by one or more of the rows, this indicates that a key located at the intersection between that column and the one or more rows has been pressed. A simple key matrix is shown in figure 1.

A problem arises when the keys are mechanical devices, as such devices tend to be subjected to contact bounce (or chatter) when the contacts are forced together or when they separate. Contact bounce is caused by the momentum and elasticity of the contacts and results in a rapidly pulsed electrical current, as shown in figure 2. This high frequency oscillation causes problems because it can be detected by the keyboard controller and results in so-called 'false-triggering', in which the keyboard controller detects multiple key strokes from a single key depression by the user. The signal output from a mechanical switch is therefore typically passed through a 'debouncing' circuit to remove this high frequency chatter.

A debouncing circuit is a circuit that receives an input switch signal containing high frequency chatter superimposed on a lower frequency keying signal. The role of the debouncing circuit is to remove the high frequency chatter while retaining the lower frequency keying signal.

A simple debouncing circuit is shown in figure 3. The circuit comprises a resistor 301 and a capacitor 302. The debouncing circuit is a simple RC circuit that acts as a lowpass filter and thereby removes the high frequency chatter from the switch output. The resistance and capacitance values are chosen to give an appropriate frequency response for expected keying and chatter frequencies. The problem with this circuit is its slow response. Some key presses may therefore not be represented in the 'debounced' output signal.

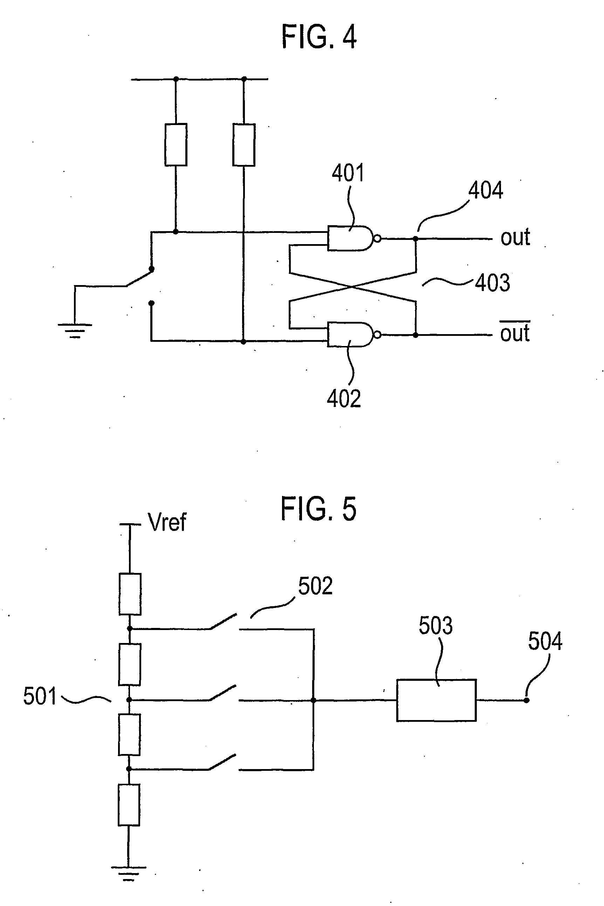

An improved debouncing circuit is shown in figure 4. This circuit comprises two NAND gates 401, 402 arranged as a 'set-reset' flip-flop 403. The debounced signal is output at node 404. This circuit successfully removes high frequency chatter from the switch signal, has a fast response and outputs a digital signal suitable for supplying to a keyboard controller. This circuit does however have the disadvantage that it can only receive and successfully debounce a single switch. For switches that are arranged in key matrices, therefore, a separate debouncing circuit being provided for each switch. Typically, the switch debouncing circuitry is to be hardwired into the matrix circuit. This is costly and uses valuable space.

The current signal may be advantageously detected by passing it through an impedance, such as a potential divider, so that signal of varying amplitude is output by each row of the matrix as the keyboard sequentially activates each of the columns. This signal therefore represents the status of each of the keys of the keyboard scanned from one end of the keyboard to the other. If the signal has previously been debounced, then the varying signal is typically input into a keyboard controller, which analyses the analogue signal to determine which of the keys have been depressed and outputs the resulting data to an overall controller, e.g. such as the operating system of a computer.

One alternative to debouncing each switch individually in hardware is to debounce a switch signal in software.

However, this requires a software controlled processor to be provided in the neighbourhood of the keyboard or keypad in whatever device the keyboard or keypad has been incorporated into. This is problematic in space-limited implementations. For example, portable audio players such as MP3 players often have a small user input device incorporating switches located on a lead between the device and a set of headphones. With such small user input devices, it would be preferable if debouncing of the switches could be performed in hardware within the device itself before the final switch signal is transmitted over the lead to the portable media player.

An alternative switch matrix to that illustrated in figure 1 is shown in figure 5. This switch matrix is arranged as a potential divider 501, with each switch 502 being located at a different level in the divider. In a switch matrix according to this arrangement, each switch causes a different voltage to be output from the matrix when it is depressed. Therefore, a depressed switch can be identified by the voltage output by the matrix. If the switches are mechanical, then they need to be debounced as described above. This form of switch matrix has the additional requirement that any debouncing process must preserve the difference between the signals output by each switch, so that the different switches can still be identified.

There is therefore a need for an improved circuit for debouncing a switch signal.

According to a first aspect of the invention, there is provided a switch circuit comprising a mechanical switch having two contact elements, the switch being operable to bring the two contact elements into physical contact and thereby output an analogue switch signal representative of operation of the switch and a sigma-delta modulator arranged to receive the analogue switch signal and to output a digital switch signal in dependence thereon, the sigma-delta modulator having a frequency response such that it can suppress a relatively high frequency component of the analogue input signal and thereby effectively debounce the output of the switch.

The switch circuit may comprise a plurality of mechanical switches and the switch circuit is arranged such that a single analogue switch signal representative of the operation of each of the plurality of switches is output by the plurality of switches and received by the sigma-delta modulator.

The switch circuit may comprise an array of switches extending in two dimensions, each switch being located on a row in the first dimension and a column in the second dimension and each row of the array being arranged to output a single analogue switch signal representative of the operation of each of the switches located in that row.

The switch circuit may be arranged to sequentially activate each column of the array by applying an electric current to each column in turn, the instantaneous value of the single analogue switch signal output by a row of the array being representative of the operation of a switch located in the currently activated column of that row.

The switch circuit may be arranged such that operation of one of a plurality of switches causes the single analogue switch signal to have a specific voltage level. The specific voltage level may be the same irrespective of which switch has been operated. Alternatively, the specific voltage level is dependent on which switch has been operated.

Each switch located in a row of the array may be associated with a specific voltage level such that operation of a switch in that row causes the single analogue switch signal to have the specific voltage level associated with the operated switch. A row of the array may comprise a potential divider and each switch located in that row may be connected to a specific voltage level within the potential divider such that operation of a switch causes the single analogue switch signal to have the specific voltage level connected to the operated switch.

The sigma-delta modulator may comprise a summation unit for summing the analogue switch signal with an adjustment signal to form a summation output signal, an integrator arranged to receive the summation output signal and form an integrator output signal dependent thereon, a quantiser arranged to receive the integrator output signal and form the digital switch signal dependent thereon and a feedback loop for generating the adjustment signal.

The feedback loop may comprise a digital-to-analogue converter for receiving the digital output signal and generating the adjustment signal in dependence thereon.

The feedback loop may comprise a logic circuit arranged to select between one of two predetermined values for the adjustment signal, the selection being performed in dependence on both the digital output signal and a control signal.

The feedback loop may comprise a selection circuit arranged to select between one of two boundary values for the adjustment signal, the selection being performed in dependence on the digital output signal.

The sigma-delta modulator may be arranged to sample the analogue input signal at a sampling rate that exceeds a maximum frequency of operation of the mechanical switch by a user. The operation of the mechanical switch is suitably the activation of the switch so as to bring the two contact elements into physical contact. The sampling rate may exceed 20Hz.

The sigma-delta modulator may be arranged to receive a clock signal of 5.12 kHz or above.

The sigma-delta modulator may be configured to low-pass filter the analogue switch signal.

The sigma-delta modulator may have a frequency response such that it can suppress the relatively high frequency component of the analogue input signal relative to a lower frequency component of the analogue input signal that is representative of operation of the mechanical switch by a user.

According to a second aspect of the invention, there is provided a use of a sigma-delta modulator to debounce an output of a mechanical switch.

For a better understanding of the present invention, reference is made by way of example to the following drawings, in which:

Figure 1 shows a switch matrix;

Figure 2 shows a switch signal exhibiting chatter;

Figure 3 shows a simple debouncing circuit;

Figure 4 shows a debouncing circuit including a 'set-reset' flip-flop;

Figure 5 shows a switch matrix in which each switch causes a different voltage level to be output from the matrix when it is depressed;

Figure 6 shows a debouncing circuit;

Figures 7a-c show the effect of oversampling and digital filtering on the output noise level of an ADC;

Figures 8a-b show the effect of noise shaping on the output noise level of an ADC;

Figure 9 shows an overview of the stages involved in reducing noise levels in the output signal;

Figure 10 shows the effects of decimation on noise reduction;

Figure 11 shows a sigma-delta modulator;

Figures 12 shows waveforms for implementing a gain function in a sigma-delta modulator;

Figures 13 shows waveforms for implementing a gain function in a sigma-delta modulator;

Figure 14 shows a further sigma-delta modulator;

Figure 15 shows a representation of the elements contributing to a sigma-delta modulator's frequency response.

A switch circuit comprises a mechanical switch and a sigma-delta modulator for debouncing the switch output. The sigma-delta modulator is capable of converting the analogue signal output by the mechanical switch into a digital signal. The frequency response of the sigma-delta modulator may be such that it removes any high frequency chatter component from the switch output, e.g. by low-pass filtering the analogue switch signal.

A sigma-delta modulator is capable of receiving a continuous analogue input signal and of continuously debouncing that input signal. This has the advantage that a separate debouncing circuit need not therefore be provided for every switch. Instead, multiple switches can be debounced by a single sigma-delta modulator. This can be achieved by forming a single analogue input signal representative of the status of multiple switches and inputting this signal into the sigma-delta modulator. For example, the sigma-delta modulator may receive an analogue switch signal that is generated by a row of switches in a switch matrix. Such a signal can be formed e.g. by a key scanning keyboard such as that shown in figure 1 and described above, in which each column of a switch matrix is activated in turn.

The current signal output by a row of a switch matrix such as that illustrated in figure 1 may be advantageously detected by passing it through an impedance, such as the potential divider. This generates an analogue switch signal of varying amplitude that is output by each row of the matrix as the keyboard sequentially activates each of the columns. This analogue signal therefore represents the status of each of the keys of the keyboard scanned from one end of the keyboard to the other. This signal can the be input into a sigma-delta modulator to be digitised and debounced.

A sigma-delta modulator is also advantageous in switch matrices such as the one illustrated in figure 5, in which activation of each switch causes a different voltage to be output from the matrix. In figure 5, the sigma-delta modulator 503 is arranged to receive the output of the switch matrix, which will vary in amplitude depending on which of the switches has been operated. This variation in voltage level can be used to identify which of the switches has been operated. Because the sigma-delta modulator is effectively an analogue-digital-converter, the digital switch signal output at node 504 is representative of the voltage level of the analogue switch signal. Thus, the sigma-delta modulator debounces the switch output while preserving its ability to identify the switches that have been activated.

Different implementations of sigma-delta modulators that are suitable for being used as debouncing circuits will now be described. These specific implementations are given for the purposes of example only and it should be understood that the invention is not limited to any specific implementation of a sigma-delta modulator.

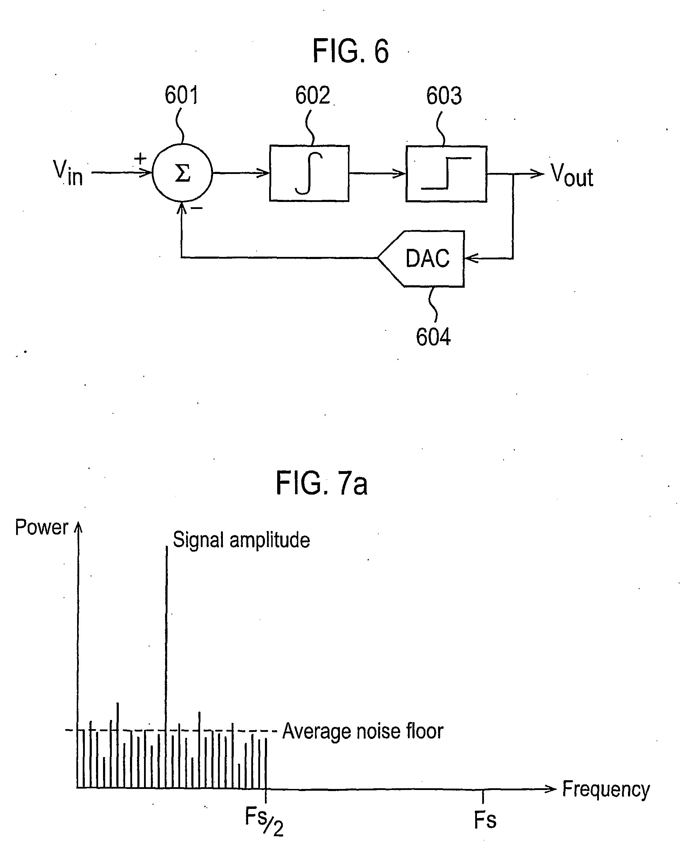

The operation of a sigma-delta modulator is best described using the simplest 1-bit implementation. A 1-bit sigma-delta modulator is illustrated in figure 6.

In the basic implementation illustrated in figure 6, the sigma-delta modulator comprises a summation unit 601, an integrator 602, a comparator 603 and a digital-to-analogue converter (DAC) 604. The summation unit may be, for example, a difference amplifier. The comparator may be an analogue-to-digital converter (ADC).

As can be seen in figure 6, the components of the modulator are connected in a feedback loop. The analogue input signal is fed into the summation unit, where a feedback signal is subtracted, before being fed into a loop filter, which in this case is an integrator. The signal output from the integrator is compared with a reference signal in the comparator. If the output signal from the integrator is greater than the reference signal, a 'one' is output, and if the integrator output signal is less than the reference signal, a 'zero' is output. Thus the analogue input signal has been converted into a digital output signal.

The digital output signal is fed back, via the DAC, to the summation unit, where it is subtracted from the input signal. The purpose of the feedback signal is to maintain the average output of the integrator near the comparator's reference level by making the ones and zeros of the digital output signal representative of the analogue input.

The DAC in the feedback loop has an upper reference voltage and a lower reference voltage. When the comparator outputs a 'one', the DAC outputs a signal at the upper voltage and when the comparator outputs a 'zero', the DAC outputs a signal at the lower voltage. The modulator is at full-range scale when the input signal is equal to the upper or lower reference voltages of the feedback DAC. For example, if the feedback DAC outputs -2.5V when it receives a zero and 2.5V when it receives a one then the range of the input is $\pm$2.5V. The reference voltage of the comparator is halfway between the upper and lower boundaries of the input range, e.g. for an input range of $\pm$2.5V the reference voltage for the comparator would be 0V. The reference voltage for the comparator represents the virtual ground level for the modulator. For modulators having an input range that is symmetrical about zero, the virtual ground level is zero.

The output from the sigma-delta modulator is a stream of ones and zeros. The ratio of ones to zeros represents the magnitude of the input signal compared with the input range of the modulator. For example, if the range of the modulator is $\pm$2.5V and the input signal has a magnitude of 1.0V, then the input signal is 3.5V above the lower boundary of a 5V range. In this example, 70% of the output signal should consist of ones. For the modulator to produce a digital output signal that is an accurate representation of the analogue input signal, the modulator must sample at a much greater rate than the rate of change of the analogue input signal.

More sophisticated sigma-delta modulators than the 1-bit modulator described above may have multiple modulators and integrators.

For a sigma-delta modulator as described herein, the component of the analogue input signal to be converted into a digital output signal is the signal corresponding to operation of the switch(es) by a user. Therefore, in order for this switch or keying signal to be successfully converted to a digital output signal, the modulator must sample at a much greater rate than the rate at which the switch(es) can be expected to be operated by the user. Key presses by a user can be expected not to exceed 20 Hz (i.e. 20 keypresses per second). The clocking frequency of the modulator is suitably be at least S x F Hz, where S is the number of pulses that constitute a maximum measurement value and F is the sampling rate of the converter. The modulator is suitably clocked at at least 5.12 kHz. In practice, however, a much higher rate than may be used.

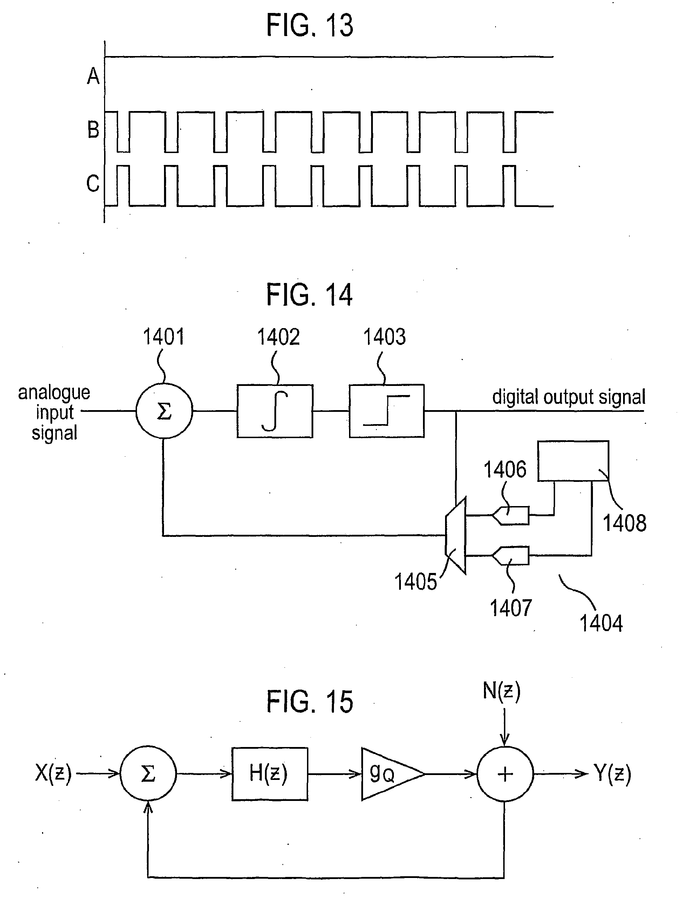

A sigma-delta modulator may have a frequency response that successfully suppresses the high frequency chatter component of the switch output while retaining and successfully digitising the part of the switch output representing activation and deactivation of the switch. The frequency response of the sigma-delta modulator is dependent on the exact implementation of the modulator. However, if the sigma-delta modulator is generally considered to consist of a loop filter having transfer function H(z) and a quantising amplifier having gain $g_Q$, as shown in figure 15, then the signal transfer function is as follows:

$$H_X(z) = \frac{Y(z)}{X(z)} = \frac{g_Q H(z)}{1 + g_Q H(z)} \qquad (1)$$

where

$$z = e^{j\frac{\omega}{\omega_s}}$$

By choosing an appropriate sampling frequency for a specific implementation of a sigma-delta modulator, the frequency response of the modulator can be chosen so as to preserve or amplify frequency components of the switch signal associated with operation of the switch and to remove frequency components associated with bouncing between the switch contacts. For a typical sigma-delta modulator, a suitable range for the sampling frequency is 0.4 to 4.0 kHz.

The noise transfer function for the quantisation noise N(z) introduced by the quantiser is as follows:

$$H_N(z) = \frac{Y(z)}{N(z)} = \frac{1}{1 + g_Q H(z)} \qquad (2)$$

Thus, if the modulator acts as a low pass filter to the input switch signal, it can be expected to act as a high pass filter to the quantisation noise. This is described in more detail below.

A sigma-delta modulator offers improved noise performance over traditional ADCs. This is achieved through oversampling, noise shaping, digital filtering and decimation.

A traditional multi-bit ADC converts an analogue signal into a digital signal by sampling the input signal at regularly spaced intervals in time and classifying the magnitude of the input signal as being one of a number of equally spaced, predetermined magnitudes. The simplest 1-bit ADC classifies the input signal according to two predetermined magnitude levels and the outputs either a one or a zero according to which of the two levels the input signal is closest to. Likewise, a 2-bit ADC classifies the input signal according to four predetermined levels and outputs either 00, 01, 10 or 11 during each sampling period and so on. The greater the number of magnitude levels to which the input signal is compared, the greater the resolution of the converter. By according the input signal one of an equally spaced number of values the output of the ADC is inherently inaccurate. This is because the ADC input is a continuous signal with an infinite number of possible states while the output signal is a discrete function whose number of different states is determined by the converter's resolution. The conversion from analogue to digital loses some information and introduces distortion into the signal. The magnitude of this error is random, with values up to $\pm$LSB (the least significant bit of the digital output).

A typical graph that would be obtained from an FFT analysis of the output signal from a traditional multi-bit ADC with a sine-wave input signal is illustrated in figure 7a. Fs is the sampling frequency of the input signal, which must be at least twice the bandwidth of the input signal according to Nyquist theory. The FFT analysis breaks down the signal into its frequency components. The sine-wave is clearly visible as a large spike at a single frequency. However, lots of random noise is also visible extending from DC to Fs/2. This noise is a result of the distortion discussed above and is known as quantisation noise.

The signal-to-noise ratio (SNR) is obtained by dividing the signal amplitude by the RMS sum of all the frequencies representing noise. In a conventional ADC the SNR can only be improved by increasing the resolution i.e. the number of bits.

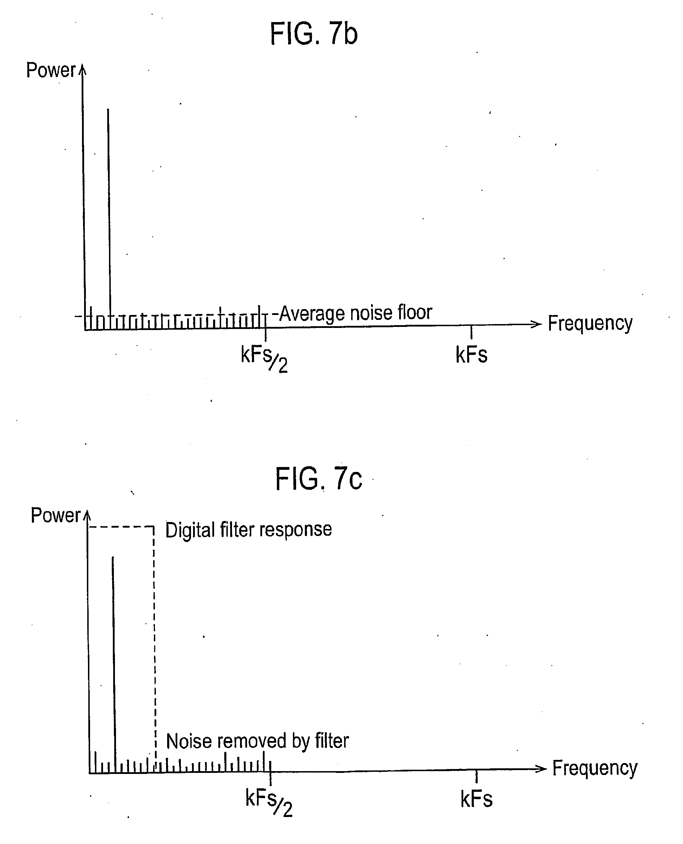

If the sampling frequency is increased by the oversampling ratio k, to kFs, the noise floor drops. This is illustrated in figure 7b. The SNR is unchanged from the situation in figure 7a, but the noise has been spread over a wider frequency range. Sigma-delta converters are able to exploit this effect by following the 1-bit ADC with a digital filter. The effect of the filter is illustrated in figure 7c. The RMS noise is less, because most of the noise passes through the digital filter. This action allows sigma-delta modulators to achieve a wide dynamic range from a low-resolution ADC.

However, the sigma-delta modulator cannot achieve a high resolution from oversampling alone as the oversampling ratio required for even a reasonable resolution is generally too high to be realisable. The sigma-delta modulator also shapes noise away from the peak gain response of the modulator.

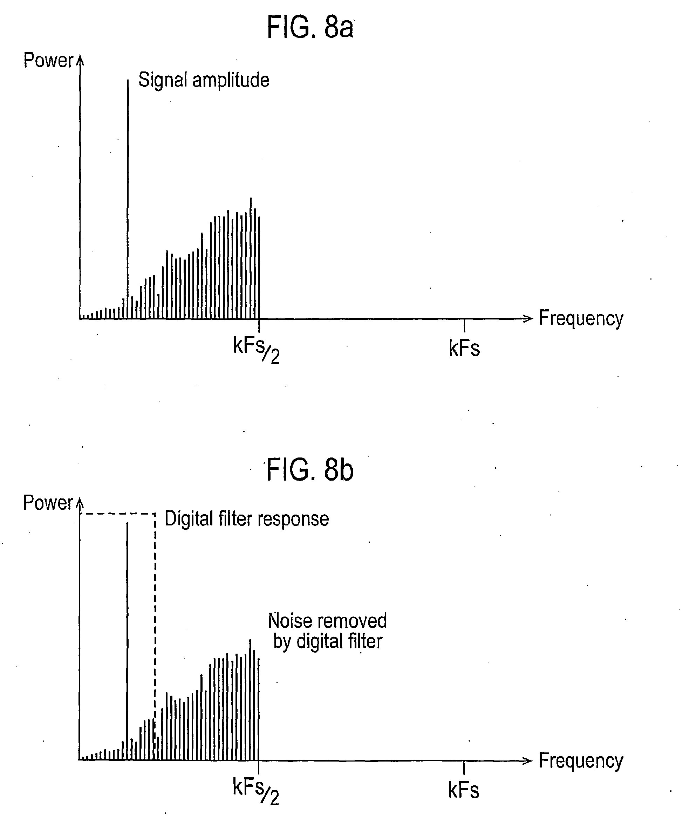

In the modulator illustrated in figure 6, the loop filter is an integrator, so the modulator shapes noise out of the lower frequencies and into the higher frequencies. This is because the integrator sums the error voltage, thereby acting as a lowpass filter to the input signal and a high pass filter to the quantisation noise. Thus, most of the quantisation noise is pushed into higher frequencies (see figure 8a). Oversampling has not changed the total noise power, but its distribution.

For higher order sigma-delta modulators, noise shaping can be achieved by including more than one stage of integration and summation.

If a digital filter is applied to the noise-shaped output of the sigma-delta modulator, as illustrated in figure 8b, it removes more noise than does oversampling alone.

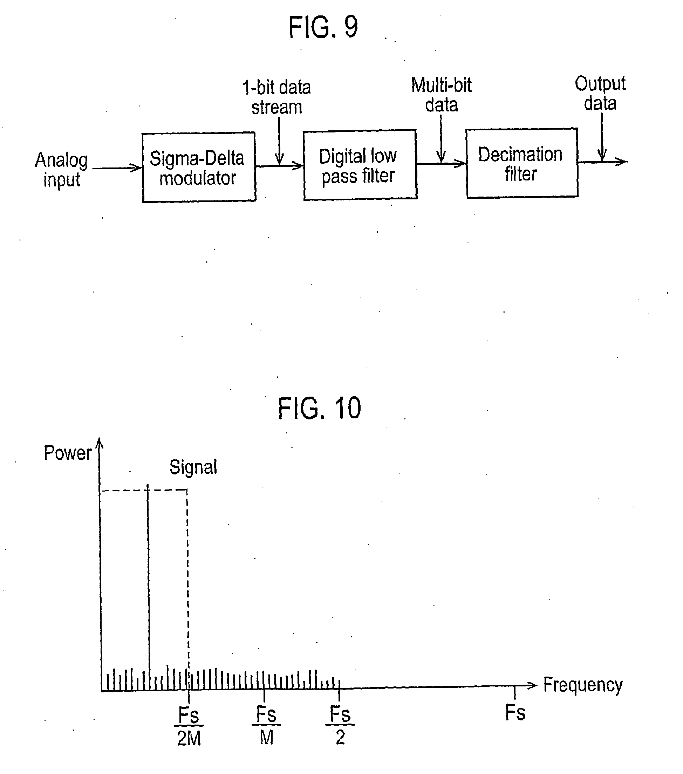

The output of the sigma-delta modulator is a stream of ones and zeros at the sampling rate. This data rate is usually very high, so a digital-and-decimation filter can be used to reduce the data rate to a more useful value. No useful information is lost during this process, as illustrated in figure 10. As the bandwidth of the signal is reduced by the digital output filter, the output data rate can satisfy the Nyquist criterion even though it is lower that the original sampling rate. This can be accomplished by preserving certain input values and discarding the rest. This process is known by decimation by a factor M (the decimation ratio). M can have any integer value, provided that the output data rate is more than twice the signal bandwidth. If the input has been sampled at Fs, the filtered-output data rate can be reduced to Fs/M without loss of information. The complete system, as described, above is illustrated in figure 9.

The sigma-delta modulator offers best resolution when the input signal varies between the upper and lower limits of the modulator's input range. The upper and lower limits can be considered as $\pm$Vcc/2 about the virtual ground level of the modulator (i.e. the modulator has an input range of Vcc). One option for optimising the resolution of the sigma-delta modulator is to implement a gain function in a sigma-delta modulator by introducing transition-cycles into the feedback path. Transition-cycles have a net average value equal to the virtual ground level of the modulator. By introducing more transition-cycles into the feedback path the overall average level of the feedback is reduced.

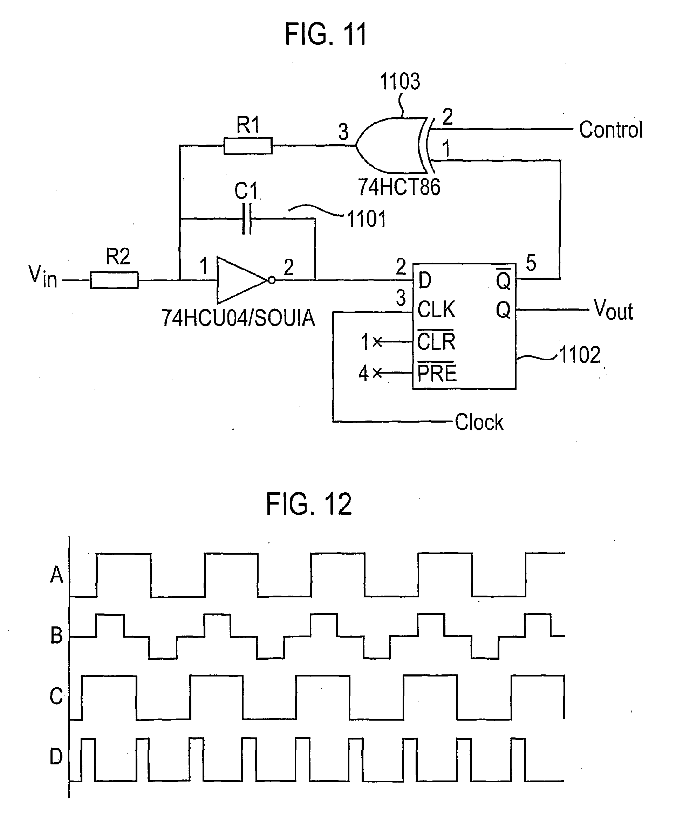

Figure 11 illustrates a sigma-delta modulator that introduces transition-cycles into the feedback path. The loop filter 1101 is an integrator circuit, the quantiser is a latch 1102 and the feedback DAC has been replaced by an exclusive-OR gate (an XOR gate) 1103. The XOR gate has as its inputs the digital feedback signal and a control signal.

Waveform A of figure 12 shows a typical feedback signal for an input that is at the virtual ground level. In figure 12, the virtual ground level has been set at ½Vcc. The signal has a 50% duty cycle, i.e. half the cycles take the upper limit of Vcc and half the lower limit of 0V. The signal therefore represents an input having a magnitude that is midway between the upper and lower limits of the input range of the modulator i.e. ½Vcc in this case.

Waveform B of figure 12 illustrates an equivalent feedback signal including transition-cycles. Waveform A, which is a non-return-to-zero or NRZ waveform, has been converted to a return-to-zero (RTZ) waveform. As can be seen from the figure, the transition-cycles have a net average value of ½Vcc (virtual ground).

Waveform B illustrated in figure 12 is difficult to directly synthesise. However, since the requirement for the transition-cycles is only that their net average value is equal to the virtual ground level, waveform C in figure 12 will have the same effect on the overall feedback level seen by the integrator as waveform B. In waveform C the transition-cycles have, in effect, been implemented as a pair of pulses, having an average value of ½Vcc.

Waveform C can be easily generated from waveform A by using an XOR gate with waveform D (also illustrated in figure 12). Therefore, in the sigma-delta modulator shown in figure 7, the digital output signal (waveform A) and the control signal (waveform D) are input into an XOR gate to create the feedback signal (waveform C). Note that the feedback signal still has a 50% duty cycle so the modulator is still balanced with an input of ½Vcc. In other words, for an input signal at virtual ground, the situation is unchanged by the introduction of transition-cycles into the feedback signal.

Waveforms A, B and C of figure 13 are similar waveforms for the situation where the modulator has a full scale positive input (Vcc). The digital output signal of the modulator is waveform A. As the input is at the upper limit, the output signal is always high (100% ones). If the same control signal (waveform C) were applied to the XOR gate along with the digital output signal, then the feedback waveform B is generated. This time, the feedback signal has a net DC content of ¾Vcc. Therefore, an input of ¾Vcc would be balanced by this feedback signal and the upper input limit to the modulator has been reduced by ¼Vcc.

Similarly, if the input to the modulator has a full scale negative input (0V), the same control signal would produce a feedback signal having a net DC content of ¼Vcc.

Therefore, an input of ¼Vcc would be balanced by this feedback signal and the upper input limit to the modulator has been increased by ¼Vcc.

Therefore, overall, the waveform D of figure 12 and waveform C of figure 13 have managed to decrease the input range of the modulator from Vcc to ½Vcc. The modulator has an implied gain of two. By reducing the input range into the modulator by half, the control signal has effectively achieved the same result as an amplification by a factor of two prior to the sigma-delta modulator.

The control and feedback signals may have a higher frequency than the digital output signal. To achieve this the XOR gate and the quantiser can receive different clock signals.

The control signal can also be used to apply an offset. This can be achieved using the same basic circuit as illustrated in figure 11. In this application, the control signal is arranged such that transition-cycles are injected into the feedback signal in an asymmetric manner. Replacing more 'ones' than 'zeros' in the output signal, causes the generated feedback signal to apply a positive offset to the input signal. This is because the net DC content of the feedback signal is decreased relative to the situation where the same number of transition-cycles is inserted into the feedback signal, but in a symmetric manner. Similarly, by replacing more 'zeros' than 'ones', a negative offset can be applied.

Introducing transition cycles into the feedback signal means that some of the spectral noise shaping information is removed. There is therefore inevitably a reduction in the SNR that is achievable by the modulator. For example, in the situation where the control signal is of the form of waveform D of figure 12 and waveform C of figure 13, we have a situation where a quarter of the signal being fed back into the modulator is replaced with transition-cycles. In other words, only 75% of the feedback signal comprises noise shaping content while the remaining 25% comprises gain scaling (and offset) content. Therefore, for a gain of 6dB (a factor of 2), the SNR degradation is 2.5dB (a factor of approximately 1.3).

A sigma-delta modulator having an improved noise performance is illustrated in figure 14.

As explained above, the allowable input range of a sigma-delta modulator is determined by the upper and lower voltages of the feedback signal. In one embodiment, the upper and lower voltages of the feedback signal are set by two boundary voltages. The feedback signal is formed by using the digital output signal to select between the two boundary voltages. The implied gain and offset of the sigma-delta modulator is controlled by selecting appropriate values for the boundary voltages.

A sigma-delta modulator in which effective gain and offset are controlled by setting boundary voltages is illustrated in figure 14. The modulator comprises a summation unit 1401, an integrator 1402, a quantiser 1403 and a selection circuit 1404 connected in a feedback loop.

The summation unit is arranged to receive an analogue input signal and an adjustment signal, which is output by the selection circuit. The summation unit subtracts the adjustment signal from the analogue input signal and outputs the subtracted signal to the integrator. The integrator filters the subtracted signal and outputs the filtered signal to the quantiser, which compares the integrated signal to a reference signal in the comparator. If the output signal from the integrator is greater than the reference signal, a 'one' is output, and if the integrator output signal is less than the reference signal, a 'zero' is output. Thus the analogue input signal has been converted into a digital output signal.

The modulator outputs the digital output signal. The digital output signal is also fed back to the selection circuit. The role of the selection circuit is to set the input range of the sigma-delta modulator via the adjustment signal.

The selection circuit shown in figure 10 comprises a multiplexor 1405, a first DAC 1406, a second DAC 1407 and a control unit 1408. The multiplexor receives as inputs the digital output signal and two boundary values. Each boundary value is a voltage output from a respective one of the two DACs. The first DAC outputs a first boundary value and the second DAC outputs a second boundary value. The voltage output by each DAC is controlled by a control signal generated by the control unit. The control unit is therefore able to control the boundary values input into the multiplexor via the two control signals.

The control unit may be implemented in software. The control signals generated by the control unit may be digital signals.

The digital output signal controls which of the two boundary values is output by the mutliplexor at any given time. When the digital output signal is high, i.e. when the sigma-delta modulator is outputting a 'one', the multiplexor outputs one of the two boundary values. When the digital output signal is low, i.e. when the sigma-delta modulator is outputting a 'zero', the multiplexor outputs the other of the two boundary values. The adjustment signal output by the multiplexor therefore contains the same sequence of ones and zeros as the digital output signal, but with the voltage level of each 'one' and 'zero' in the digital output signal replaced by a respective one of the two boundary values. The upper and lower limits between which the adjustment signal varies can therefore be controlled by adjusting the two boundary values. In this way, the gain and offset applied to the analogue input signal by the sigma-delta modulator can be directly controlled by the control unit.

A switch circuit may therefore advantageously use a sigma-delta modulator to receive an analogue signal output from a series of switches, low pass filter that analogue signal to remove the unwanted chatter frequencies and output a digital switch signal. That digital switch signal may then be received by e.g. a keyboard controller.

The digital output signal output from a sigma-delta modulator is a pulse-density modulated signal that represents the analogue input signal as a bit stream of ones and zeros. The sigma-delta modulator in the switch circuit suitably low-pass filters the analogue input signal. This results in a pulse-density modulated output signal in which the parts of the signal representative of the high frequency components of the analogue input signal (resulting from contact bounce) are suppressed relative to the parts of the signal representative of the lower frequency components of the analogue input signal (resulting from user-activation of the switch).

It should be understood that the first-order sigma-delta modulators as described above are only examples, and that the principle of the invention remains the same for other modulators. Any kind of sigma-delta modulator could be used, for example, analogue, digital or switched capacitor. The loop filter has been shown specifically as an integrator. However, any loop filter that provides a modulator having a low pass frequency response with respect to the input signal could be used. Although the quantiser has been shown as a two-level type, it could have any number of levels. The method according to the present invention is applicable to any order of modulator.

As described above, one application in which a sigma-delta modulator may be advantageously used as a debouncing circuit is in portable media players having a user input device involving a keypad located on a lead between the media player and a set of earphones. In such an application, a sigma-delta modulator can advantageously be used to generate a single digital output stream from multiple keys. In this way, only a single wire is needed to carry the digital signal representing the keyed input to the media player for processing. Alternatively, the user input device may itself contain a keyboard controller and so be able to issue commands according to the keyed inputs, e.g. by sending a volume control circuit to the earphones.

Each sigma-delta modulator may receive an input signal generated by a single row in a scanned key matrix. Alternatively, the scanned key matrix may generate a single output stream indicative of the status of each of the switches in the matrix. This may be achieved by feeding each of the signals output by a row into a multiplexor that selects between analogue signals output by each row of the matrix in turn to generate a single analogue output signal. The multiplexor may be clocked at a faster rate than the sequential activation of the matrix columns, so that the multiplexor outputs the signal for each row during the time for which a single column is activated.

The single output signal may then be input to the sigma-delta modulator for filtering and conversion into digital form.

Although a sigma-delta modulator may advantageously used as a debouncing circuit for applications having multiple switches, a sigma-delta modulator may also be advantageously used in applications involving a single switch. A sigma-delta modulator provides a debouncing circuit that effectively removes chatter while providing a fast response. A sigma-delta modulator also provides the opportunity to implement effective gain and offset, as described above.

**Claims**

1. A switch circuit comprising:

   a mechanical switch having two contact elements, the switch being operable to bring the two contact elements into physical contact and thereby output an analogue switch signal representative of operation of the switch; and a sigma-delta modulator arranged to receive the analogue switch signal and to output a digital switch signal in dependence thereon, the sigma-delta modulator having a frequency response such that it can suppress a relatively high frequency component of the analogue input signal and thereby effectively debounce the output of the switch.

2. A switch circuit as claimed in claim 1, wherein the switch circuit comprises a plurality of mechanical switches and the switch circuit is arranged such that a single analogue switch signal representative of the operation of each of the plurality of switches is output by the plurality of switches and received by the sigma-delta modulator.

3. A switch circuit, as claimed in claim 2, wherein the switch circuit comprises an array of switches extending in two dimensions, each switch being located on a row in the first dimension and a column in the second dimension and each row of the array being arranged to output a single analogue switch signal representative of the operation of each of the switches located in that row.

4. A switch circuit as claimed in claim 3, wherein the switch circuit is arranged to sequentially activate each column of the array by applying an electric current to each column in turn, the instantaneous value of the single analogue switch signal output by a row of the array being representative of the operation of a switch located in the currently activated column of that row.

5. A switch circuit as claimed in any of claims 2 to 4, wherein the switch circuit is arranged such that operation of one of a plurality of switches causes the single analogue switch signal to have a specific voltage level.

6. A switch circuit as claimed in claim 5, wherein the specific voltage level is the same irrespective of which switch has been operated.

7. A switch circuit as claimed in claim 5, wherein the specific voltage level is dependent on which switch has been operated.

8. A switch circuit as claimed in claim 7, wherein each switch located in a row of the array is associated with a specific voltage level such that operation of a switch in that row causes the single analogue switch signal to have the specific voltage level associated with the operated switch.

9. A switch circuit as claimed in claim 8, wherein a row of the array comprises a potential divider and each switch located in that row is connected to a specific voltage level within the potential divider such that operation of a switch causes the single analogue switch signal to have the specific voltage level connected to the operated switch.

10. A switch circuit as claimed in any preceding claim, wherein the sigma-delta modulator comprises:

a summation unit for summing the analogue switch signal with an adjustment signal to form a summation output signal;

an integrator arranged to receive the summation output signal and form an integrator output signal dependent thereon;

a quantiser arranged to receive the integrator output signal and form the digital switch signal dependent thereon; and

a feedback loop for generating the adjustment signal.

11. A switch circuit as claimed in claim 10, wherein the feedback loop comprises a digital-to-analogue converter for receiving the digital output signal and generating the adjustment signal in dependence thereon.

12. A switch circuit as claimed in claim 10, wherein the feedback loop comprises a logic circuit arranged to select between one of two predetermined values for the adjustment signal, the selection being performed in dependence on both the digital output signal and a control signal.

13. A switch circuit as claimed in claim 10, wherein the feedback loop comprises a selection circuit arranged to select between one of two boundary values for the adjustment signal, the selection being performed in dependence on the digital output signal.

14. A switch circuit as claimed in any preceding claim, wherein the sigma-delta modulator is arranged to sample the analogue input signal at a sampling rate that exceeds a maximum frequency of operation of the mechanical switch by a user.

15. A switch circuit as claimed in claim 14, wherein the sigma-delta modulator is arranged to sample the analogue input signal at a sampling rate exceeding 20Hz.

16. A switch circuit as claimed in any preceding claim, wherein the sigma-delta modulator is arranged to receive a clock signal of 5.12 kHz or above.

17. A switch circuit as claimed in any preceding claim, wherein the sigma-delta modulator is configured to low-pass filter the analogue switch signal.

18. A switch circuit as claimed in any preceding claim, wherein the sigma-delta modulator has a frequency response such that it can suppress the relatively high frequency component of the analogue input signal relative to a lower frequency component of the analogue input signal that is representative of operation of the mechanical switch by a user.

19. Use of a sigma-delta modulator to debounce an output of a mechanical switch.


**Patentansprüche**

1. Schalterstromkreis, der aufweist:

einen mechanischen Schalter, der zwei Kontaktelemente aufweist, wobei der Schalter betätigbar ist, um die zwei Kontaktelemente in physischen Kontakt miteinander zu bringen und **dadurch** ein analoges Schaltersignal auszugeben, das für den Betrieb des Schalters kennzeichnend ist; und

einen Sigma-Delta-Modulator, der eingerichtet ist das analoge Schaltersignal entgegenzunehmen und in Abhängigkeit davon ein digitales Schaltersignal auszugeben, wobei der Sigma-Delta-Modulator einen solchen Frequenzgang aufweist, dass er eine relativ hohe Frequenzkomponente des analogen Eingangssignals unterdrücken und **dadurch** das Ausgangssignal des Schalters entprellen kann.

2. Schalterstromkreis wie in Anspruch 1 beansprucht, wobei der Schalterstromkreis eine Vielzahl von mechanischen Schaltern aufweist und der Schalterstromkreis so eingerichtet ist, dass ein einzelnes analoges Schaltersignal, das kennzeichnend ist für die Betätigung von jedem der Vielzahl von Schaltern, von der Vielzahl von Schaltern ausgegeben wird und von dem Sigma-Delta-Modulator entgegengenommen wird.

3. Schalterstromkreis, wie in Anspruch 2 beansprucht, wobei der Schalterstromkreis eine Matrix von Schaltern aufweist, die sich in zwei Dimensionen erstreckt, wobei jeder Schalter in einer Reihe in der ersten Dimension und einer Spalte in der zweiten Dimension angeordnet ist und jede Reihe der Matrix eingerichtet ist, ein einzelnes analoges Schaltersignal auszugeben, das kennzeichnend ist für die Betätigung von jedem der Schalter, die in dieser Reihe angeordnet sind.

4. Schalterstromkreis wie in Anspruch 3 beansprucht, wobei der Schalterstromkreis eingerichtet ist, jede Spalte der Matrix durch abwechselndes Anlegen eines elektrischen Stroms an jede Spalte sequentiell zu aktivieren, wobei der momentane Wert der einzelnen analogen Schaltersignalausgabe durch eine Reihe der Matrix kennzeichnend ist für die Betätigung eines Schalters, der in der gegenwärtig aktivierten Spalte dieser Reihe angeordnet ist.

5. Schalterstromkreis wie in einem der Ansprüche 2 bis 4 beansprucht, wobei der Schalterstromkreis so eingerichtet ist, dass die Betätigung von einem einer Vielzahl von Schaltern bewirkt, dass das einzelne analoge Schaltersignal einen bestimmten Spannungspegel aufweist.

6. Schalterstromkreis wie in Anspruch 5 beansprucht, wobei der bestimmte Spannungspegel der gleiche ist unabhängig davon, welcher Schalter betätigt worden ist.

7. Schalterstromkreis wie in Anspruch 5 beansprucht, wobei der bestimmte Spannungspegel davon abhängig ist, welcher Schalter betätigt worden ist.

8. Schalterstromkreis wie in Anspruch 7 beansprucht, wobei jeder in einer Reihe der Matrix angeordnete Schalter mit einem bestimmten Spannungspegel verknüpft ist, so dass die Betätigung eines Schalters in dieser Reihe bewirkt, dass das einzelne analoge Schaltersignal den bestimmten Spannungspegel aufweist, der mit dem betätigten Schalter verknüpft ist.

9. Schalterstromkreis wie in Anspruch 8 beansprucht, wobei eine Reihe der Matrix einen Potentialteiler aufweist und jeder in dieser Reihe angeordnete Schalter mit einem bestimmten Spannungspegel innerhalb des Potentialteilers verbunden ist, so dass die Betätigung eines Schalters bewirkt, dass das einzelne analoge Schaltersignal den bestimmten Spannungspegel aufweist, der mit dem betätigten Schalter verbunden ist.

10. Schalterstromkreis wie in einem der vorherigen Ansprüche beansprucht, wobei der Sigma-Delta-Modulator aufweist:

   eine Summiereinheit zur Summierung des analogen Schaltersignals mit einem Abstimmungssignal, um ein Summierungsausgangssignal zu bilden;
   einen Integrator, der eingerichtet ist das Summierungsausgangssignal entgegenzunehmen und in Abhängigkeit davon ein Integratorausgangssignal zu bilden;
   einen Größenwandler, der eingerichtet ist das Integratorausgangssignal entgegenzunehmen und in Abhängigkeit davon das digitale Schaltersignal zu bilden; und
   eine Rückkopplungsschleife zur Erzeugung des Abstimmungssignals.

11. Schalterstromkreis wie in Anspruch 10 beansprucht, wobei die Rückkopplungsschleife einen Digital-Analog-Wandler zur Entgegennahme des digitalen Ausgangssignals und zur davon abhängigen Erzeugung des Abstimmungssignals aufweist.

12. Schalterstromkreis wie in Anspruch 10 beansprucht, wobei die Rückkopplungsschleife eine Logikschaltung aufweist die eingerichtet ist, zwischen zwei vorgegebenen Werten für das Abstimmungssignal auszuwählen, wobei die Auswahl in Abhängigkeit von sowohl dem digitalen Ausgangssignal als auch einem Steuersignal durchgeführt wird.

13. Schalterstromkreis wie in Anspruch 10 beansprucht, wobei die Rückkopplungsschleife eine Auswahlschaltung aufweist die eingerichtet ist, zwischen zwei Grenzwerten für das Abstimmungssignal auszuwählen, wobei die Auswahl in Abhängigkeit von dem digitalen Ausgangssignal durchgeführt wird.

14. Schalterstromkreis wie in einem der vorherigen Ansprüche beansprucht, wobei der Sigma-Delta-Modulator eingerichtet ist das analoge Eingangssignal abzutasten mit einer Abtastrate, die eine maximale Frequenz der Betätigung der mechanischen Schalter durch einen Anwender überschreitet.

15. Schalterstromkreis wie in Anspruch 14 beansprucht, wobei der Sigma-Delta-Modulator eingerichtet ist das analoge Eingangssignal mit einer Abtastrate abzutasten, die 20 Hz überschreitet.

**16.** Schalterstromkreis wie in einem der vorherigen Ansprüche beansprucht, wobei der Sigma-Delta-Modulator eingerichtet ist ein Taktsignal mit 5,12 kHz oder darüber entgegenzunehmen.

**17.** Schalterstromkreis wie in einem der vorherigen Ansprüche beansprucht, wobei der Sigma-Delta-Modulator ausgebildet ist eine Tiefpassfilterung des analogen Schaltersignals auszuführen.

**18.** Schalterstromkreis wie in einem der vorherigen Ansprüche beansprucht, wobei der Sigma-Delta-Modulator einen solchen Frequenzgang aufweist, dass er die relativ hohe Frequenzkomponente des analogen Eingangssignals relativ zu einer niedrigeren Frequenzkomponente des analogen Eingangssignals unterdrücken kann, die kennzeichnend ist für die Betätigung des mechanischen Schalters durch einen Anwender.

**19.** Verwendung eines Sigma-Delta-Modulators, um ein Ausgangssignal eines mechanischen Schalters zu entprellen.

## Revendications

**1.** Circuit de commutation comprenant :

un commutateur mécanique ayant deux éléments de contact, le commutateur pouvant être mis en oeuvre pour amener les deux éléments de contact en contact physique et donc délivrer un signal de commutation analogique représentatif de l'actionnement du commutateur ; et
un modulateur sigma-delta conçu pour recevoir le signal de commutation analogique et délivrer, en fonction de celui-ci, un signal de commutation numérique, le modulateur sigma-delta ayant une réponse en fréquence de façon à pouvoir supprimer une composante de fréquence relativement élevée du signal d'entrée analogique et donc éliminer efficacement les rebonds de la sortie du commutateur.

**2.** Circuit de commutation selon la revendication 1, lequel circuit de commutation comprend une pluralité de commutateurs mécaniques et le circuit de commutation est agencé de façon qu'un seul signal de commutation analogique, représentatif de l'actionnement de chaque commutateur de la pluralité de commutateurs, soit sorti par la pluralité de commutateurs et reçu par le modulateur sigma-delta.

**3.** Circuit de commutation selon la revendication 2, lequel circuit de commutation comprend un réseau de commutateurs s'étendant dans deux dimensions, chaque commutateur étant situé sur une rangée dans la première dimension et sur une colonne dans la seconde dimension et chaque rangée du réseau étant agencée pour sortir un seul signal de commutation analogique représentatif de l'actionnement de chacun des commutateurs situés dans cette rangée.

**4.** Circuit de commutation selon la revendication 3, lequel circuit de commutation conçu agencé pour activer séquentiellement chaque colonne du réseau en appliquant un courant électrique sur chaque colonne, tour à tour, la valeur instantanée du seul signal de commutation analogique sorti par une rangée du réseau étant représentative de l'actionnement d'un commutateur situé dans la colonne en cours d'activation de ladite rangée.

**5.** Circuit de commutation selon l'une quelconque des revendications 2 à 4, lequel circuit de commutation est conçu de façon que l'actionnement d'un commutateur d'une pluralité de commutateurs amène le seul signal de commutation analogique à avoir un niveau de tension spécifique.

**6.** Circuit de commutation selon la revendication 5, dans lequel le niveau de tension spécifique est le même, quel que soit le commutateur qui a été actionné.

**7.** Circuit de commutation selon la revendication 5, dans lequel le niveau de tension spécifique dépend du commutateur qui a été actionné.

**8.** Circuit de commutation selon la revendication 7, dans lequel chaque commutateur situé dans une rangée du réseau est associé à un niveau de tension spécifique de façon que l'actionnement d'un commutateur dans cette rangée amène le seul signal de commutation analogique à avoir le niveau de tension spécifique associé au commutateur actionné.

**9.** Circuit de commutation selon la revendication 8, dans lequel une rangée du réseau comprend un diviseur de tension et chaque commutateur situé dans cette rangée est relié à un niveau de tension spécifique au sein du diviseur de tension de façon que l'actionnement d'un commutateur amène le seul signal de commutation analogique à avoir le niveau de tension spécifique lié au commutateur actionné.

**10.** Circuit de commutation selon l'une quelconque des revendications précédentes, dans lequel le modulateur sigma-delta comprend :

une unité de sommation pour additionner le signal de commutation analogique et un signal d'ajustement afin de former un signal de sortie de sommation ;
un intégrateur conçu pour recevoir le signal de sortie de sommation et former un signal de sortie d'intégrateur en fonction de ce signal ;
un quantificateur conçu pour recevoir le signal de sortie d'intégrateur et former le signal de commutation numérique en fonction de ce signal ; et
une boucle de rétroaction pour produire le signal d'ajustement.

**11.** Circuit de commutation selon la revendication 10, dans lequel la boucle de rétroaction comprend un convertisseur numérique/analogique destiné à recevoir le signal de sortie numérique et produire le signal d'ajustement en fonction de ce signal.

**12.** Circuit de commutation selon la revendication 10, dans lequel la boucle de rétroaction comprend un circuit logique conçu pour sélectionner l'une de deux valeurs prédéterminées pour le signal d'ajustement, la sélection étant réalisée en fonction à la fois du signal de sortie numérique et d'un signal de commande.

**13.** Circuit de commutation selon la revendication 10, dans lequel la boucle de rétroaction comprend un circuit de sélection conçu pour sélectionner l'une de deux valeurs limite pour le signal d'ajustement, la sélection étant réalisée en fonction du signal de sortie numérique.

**14.** Circuit de commutation selon l'une quelconque des revendications précédentes, dans lequel le modulateur sigma-delta est conçu pour échantillonner le signal d'entrée analogique à une fréquence d'échantillonnage qui excède une fréquence maximale d'actionnement du commutateur mécanique par un utilisateur.

**15.** Circuit de commutation selon la revendication 14, dans lequel le modulateur sigma-delta est conçu pour échantillonner le signal d'entrée analogique à une fréquence d'échantillonnage supérieure à 20 Hz.

**16.** Circuit de commutation selon l'une quelconque des revendications précédentes, dans lequel le modulateur sigma-delta est conçu pour recevoir un signal d'horloge supérieur ou égal à 5,12 kHz.

**17.** Circuit de commutation selon l'une quelconque des revendications précédentes, dans lequel le modulateur sigma-delta est configuré pour un filtrage passe-bas du signal de commutation analogique.

**18.** Circuit de commutation selon l'une quelconque des revendications précédentes, dans lequel le modulateur sigma-delta a une réponse en fréquence de façon à pouvoir supprimer la composante de fréquence relativement élevée du signal d'entrée analogique par rapport à une composante de fréquence plus faible du signal d'entrée analogique représentative de l'actionnement du commutateur mécanique par un utilisateur.

**19.** Utilisation d'un modulateur sigma-delta pour éliminer les rebonds d'une sortie d'un commutateur mécanique.

## FIG. 1

## FIG. 2

## FIG. 3

out

301

302

# FIG. 4

# FIG. 5

# FIG. 6

# FIG. 7a

# FIG. 7b

Power → (axis)
-Average noise floor
Frequency
kFs/2    kFs

# FIG. 7c

Power → (axis)
Digital filter response
Noise removed by filter
Frequency
kFs/2    kFs

# FIG. 8a

# FIG. 8b

# FIG. 9

Analog input → Sigma-Delta modulator → [1-bit data stream] → Digital low pass filter → [Multi-bit data] → Decimation filter → [Output data] →

# FIG. 10

# FIG. 11

# FIG. 12

## FIG. 13

## FIG. 14

## FIG. 15